# EUROPEAN PATENT SPECIFICATION

(11) **EP 4 273 945 B1**
(45) Date of publication and mention of the grant of the patent: **17.06.2026**
(21) Application number: 21928055.9
(22) Date of filing: 24.11.2021
(51) Int. Cl.: H10N 30/853, H10B 53/30, C04B 35/622, C04B 35/581, C23C 14/06, H03H 9/25, C01B 21/06, C23C 14/00, C23C 14/34, C23C 14/58, H03H 9/02

(54) **NITRIDE MATERIAL, PIEZOELECTRIC BODY FORMED OF SAME, AND MEMS DEVICE, TRANSISTOR, INVERTER, TRANSDUCER, SAW DEVICE AND FERROELECTRIC MEMORY, EACH OF WHICH USES SAID PIEZOELECTRIC BODY**
NITRIDVERBINDUNG, PIEZOELEKTRISCHER KÖRPER DARAUS UND MEMS-VORRICHTUNG, TRANSISTOR, WECHSELRICHTER, WANDLER, SÄGEVORRICHTUNG UND FERROELEKTRISCHER SPEICHER MIT DIESEM PIEZOELEKTRISCHEN KÖRPER
MATÉRIAU NITRURE, CORPS PIÉZOÉLECTRIQUE CONSTITUÉ DE CELUI-CI, ET DISPOSITIF MEMS, TRANSISTOR, INVERSEUR, TRANSDUCTEUR, DISPOSITIF SAW ET MÉMOIRE FERROÉLECTRIQUE UTILISANT CHACUN LEDIT CORPS PIÉZOÉLECTRIQUE

(30) Priority: 24.02.2021 JP 2021027147
(43) Date of publication of application: 08.11.2023
(73) Proprietor: National Institute of Advanced Industrial Science and Technology, Chiyoda-ku Tokyo 100-8921 (JP)
(72) Inventor: ANGGRAINI, Sri Ayu, Tosu-shi, Saga 841-0052 (JP); AKIYAMA, Morito, Tosu-shi, Saga 841-0052 (JP); UEHARA, Masato, Tosu-shi, Saga 841-0052 (JP); YAMADA, Hiroshi, Tosu-shi, Saga 841-0052 (JP); HIRATA, Kenji, Tosu-shi, Saga 841-0052 (JP)
(74) Representative: Lichtnecker, Markus Christoph
(86) International application number: PCT/JP2021/042898
(87) International publication number: WO 2022/180961

(56) References cited:
- EP-A1- 2 246 458
- WO-A1-2015/133422
- JP-A- 2013 128 267
- JP-A- 2013 148 562
- JP-A- 2013 148 562
- JP-A- 2014 236 051
- JP-A- 2014 236 051
- JP-A- 2017 045 749
- US-A1- 2013 127 300

## Description

### Technical Field

The present invention relates to a nitride material doped with scandium and at least one of silicon, germanium, and tin, a piezoelectric body formed of this nitride material, and a MEMS device, a transistor, an inverter, a transducer, a SAW device, and a ferroelectric memory using the piezoelectric body.

### Background Art

Characteristics of aluminum nitride (AlN), including elastic wave propagation velocity, Q factor (quality factor), and frequency temperature characteristics, are favorable. Thus, AIN is used for high-frequency filters in mobile phones and the like.

However, as the fifth-generation mobile communication system (5G) is starting to be used and 5G systems are gradually being introduced, high-frequency filters with wider bands, lower loss, and improved Q factors are being demanded. For example, the frequency band assigned for 5G in each country is several GHz. The high-frequency filters have thus been made capable of vibration in this frequency band by reducing the thickness of AIN piezoelectric thin films constituting the high-frequency filters. However, such measures have already reached their limit.

A high-frequency filter that has a two-layer structure including a nitride piezoelectric thin film and the same nitride piezoelectric thin film of reversed polarity stacked thereon and that can vibrate at twice the frequency as compared to a nitride piezoelectric thin film of the same thickness has been proposed (see Non-Patent Literature 1).

An aluminum nitride piezoelectric thin film doped with a predetermined concentration of germanium (Ge) has been proposed as the nitride material of reversed polarity (see Patent Literature 1).

Scandium (Sc)-doped aluminum nitride has been proposed as the piezoelectric material of a piezoelectric thin film used in a high-frequency filter (see Patent Literature 2), for example.

### Citation List

### Patent Literature

PTL 1: Japanese Patent Application Laid-Open No. 2017-45749
PTL 2: Japanese Patent Application Laid-Open No. 2009-10926
PTL 3: Japanese Patent Application Laid-Open No. 2014-236051
   PTL3 discloses a nitride material comprising carbon.
PTL 4: Japanese Patent Application Laid-Open No. JP 2013 148562 discloses a piezoelectric aluminum nitride material wherein Si is added to the formulation.

### Non Patent Literature

NPL 1: Mizuno, t. et al. in 2017 19th International Conference on Solid-State Sensors, Actuators and Microsystems (TRANSDUCERS). 1891-1894

### Summary of Invention

### Technical Problem

However, the foregoing germanium-doped aluminum nitride has had a problem of lacking high piezoelectricity. As a result, a nitrogen piezoelectric body with the aforementioned two-layer structure formed using the germanium-doped aluminum nitrogen cannot ensure wide pass bandwidth, and furthermore cannot achieve a high effectiveness in terms of insertion loss or guaranteed attenuation. Thus, such a nitrogen piezoelectric body is problematic in that it is difficult to use as a 5G high-frequency filter.

Scandium-doped aluminum nitride has had a problem that only ones having aluminum polarity (Al polarity) are available. For example, paragraph [0006] of Patent Literature 1 describes the unavailability of a piezoelectric thin film having nitrogen polarity (N polarity) with a polarization direction opposite to the direction of thin film growth. It has been assumed that no scandium-doped aluminum nitride having polarity (nitrogen polarity) with a polarization direction opposite to aluminum polarity exists.

As a result, there has been a problem that a piezoelectric body having a two-layer structure where scandium-doped aluminum nitride and the same nitride piezoelectric thin film of reversed polarity are stacked is unable to be fabricated.

In view of the foregoing circumstances, an object of the present invention is to provide scandium-doped aluminum nitride with a polarization direction of nitrogen polarity, a piezoelectric body formed of the same, and a MEMS device, a transistor, an inverter, a transducer, a SAW device, and a ferroelectric memory using the piezoelectric body.

### Solution to Problem

As a result of an intensive study on the foregoing problems, the inventors of the present invention have found a revolutionary nitride material to be described below, a piezoelectric body formed of the same, and a MEMS device and the like using the piezoelectric body.

To solve the foregoing problems, a first aspect of the present invention provides a nitride material represented by the chemical formula Sc_{X}M_{Y}Al_{1-X-Y}N, where M is at least one or more elements among Si, Ge, and Sn, X is greater than 0 and not greater than 0.4, Y is greater than 0 and not greater than 0.2, and X/Y is less than or equal to 5.

According to the first aspect, a nitride material having piezoelectricity with a polarization direction of nitrogen polarity can be provided.

A second aspect of the present invention is the nitride material according to the first aspect, wherein M is any one element among Si, Ge, and Sn.

According to the second aspect, a nitride material having higher piezoelectricity with a polarization direction of nitrogen polarity can be provided.

A third aspect of the present invention is the nitride material according to the second aspect, wherein X is greater than 0 and not greater than 0.35, Y is greater than 0 and not greater than 0.2, and X/Y is less than or equal to 5.

According to the third aspect, a nitride material having higher piezoelectricity with a polarization direction of nitrogen polarity can be provided.

A fourth aspect of the present invention is a nitride material including the nitride material **according** to any one of the first to third aspects, wherein the nitride material is disposed on a substrate, and at least one intermediate layer is disposed between the nitride material and the substrate.

According to the fourth aspect, crystallinity (degree of crystallization) of the nitride material improves. A nitride material having higher piezoelectricity with a polarization direction of nitrogen polarity can thus be provided.

A fifth aspect of the present invention is the nitride material according to the fourth aspect, wherein the intermediate layer contains at least one of the following: aluminum nitride, gallium nitride, indium nitride, titanium nitride, scandium nitride, ytterbium nitride, molybdenum, tungsten, hafnium, titanium, ruthenium, ruthenium oxide, chromium, chromium nitride, platinum, gold, silver, copper, aluminum, tantalum, iridium, palladium, and nickel.

According to the fifth aspect, crystallinity (degree of crystallization) of the nitride material improves more. A nitride material having much higher piezoelectricity with a polarization direction of nitrogen polarity can thus be provided.

A sixth aspect of the present invention is a piezoelectric thin film formed of the nitride material according to any one of the first to fifth aspects.

According to the sixth aspect, a nitride material having piezoelectricity with a polarization direction of nitrogen polarity can be provided.

A seventh aspect of the present invention is a piezoelectric body including the nitride material according to any one of the first to fifth aspects, wherein the nitride material is disposed on a surface of a scandium-containing nitride material represented by the chemical formula Sc_{Z}Al_{1-Z}N (0 < Z ≤ 0.4).

According to the seventh aspect, a piezoelectric body that can vibrate at high frequency and has high piezoelectricity can be provided.

An eighth aspect of the present invention is a piezoelectric body including a stack of at least two or more piezoelectric bodies according to the seventh aspect.

According to the eighth aspect, a piezoelectric body that can vibrate at higher frequency and has higher piezoelectricity can be provided.

A ninth aspect of the present invention is a MEMS device using the piezoelectric body according to any one of the sixth to eighth aspects.

As employed herein, a "MEMS device" may be any microelectromechanical systems and is not limited in particular. Examples include physical sensors such as a pressure sensor, an acceleration sensor, and a gyro sensor, and also include an actuator, a microphone, a fingerprint authentication sensor, and a vibration generator.

According to the ninth aspect, a MEMS device capable of contributing to a further high-frequency enhancement, miniaturization, and reduction in electricity usage of a portable device can be provided by using a piezoelectric body that can vibrate at high frequency and has high piezoelectricity.

A tenth aspect of the present invention is a transistor, an inverter, a transducer, a SAW device, or a ferroelectric memory using the nitride material according to any one of the first to fifth aspects.

As employed herein, a "transducer" refers to an element or device that converts a signal-carrying physical quantity into another type of physical quantity suitable for transmission, processing, storage, recording, display, operation, etc. A "SAW device" refers to a surface acoustic wave (SAW)-applied electronic device. Examples include an IDT-SAW device (Inter Digital Transducer-SAW device).

According to the tenth aspect, a transistor that can be operated at high speed with low loss and high output compared to conventional transistors can be provided. Moreover, a transistor having a high dielectric withstand voltage and low loss compared to conventional inverters can be provided. Furthermore, a ferroelectric memory having high spontaneous polarization and high storage performance compared to conventional ferroelectric memories can be provided. Moreover, a high-frequency wide-band transducer using nitride materials of different polarities can be provided. Furthermore, a SAW device that vibrates at high frequency compared to typical IDT-SAW devices can be provided by constituting an IDT using a piezoelectric body formed of nitride materials of different polarities.

### Brief Description of Drawings

The figures, which include carbon, are not part of the invention.
[Fig. 1] Fig. 1 is a schematic cross-sectional view of a piezoelectric thin film according to a first embodiment.
[Fig. 2] Fig. 2 is a table showing the composition and piezoelectric charge constant (d₃₃) of each piezoelectric thin film in a case where Si is used as a doping substance and an Sc concentration is fixed to approximately 10 mol%.
[Fig. 3] Fig. 3 is a table showing the composition and piezoelectric charge constant (d₃₃) of each piezoelectric thin film in a case where Si is used as a doping substance and an Sc concentration is fixed to approximately 20 mol%.
[Fig. 4] Fig. 4 is a table showing the composition and piezoelectric charge constant (d₃₃) of each piezoelectric thin film in a case where Si is used as a doping substance and an Sc concentration is fixed to approximately 30 mol%.
[Fig. 5] Fig. 5 is a graph showing a relationship between an Si concentration and d₃₃ of each piezoelectric thin film in a case where Si is used as the doping substance.
[Fig. 6] Fig. 6 is a graph showing a relationship between the Si concentration and the Sc concentration, at which the piezoelectric polarity is reversed, of each piezoelectric thin film in the case where Si is used as the doping substance.
[Fig. 7] Fig. 7 is a table showing the composition and piezoelectric charge constant (d₃₃) of each piezoelectric thin film in a case where Ge is used as a doping substance and an Sc concentration is fixed to approximately 10 mol%.
[Fig. 8] Fig. 8 is a table showing the composition and piezoelectric charge constant (d₃₃) of each piezoelectric thin film in a case where Ge is used as a doping substance and an Sc concentration is fixed to approximately 20 mol%.
[Fig. 9] Fig. 9 is a table showing the composition and piezoelectric charge constant (d₃₃) of each piezoelectric thin film in a case where Ge is used as a doping substance and an Sc concentration is fixed to approximately 30 mol%.
[Fig. 10] Fig. 10 is a graph showing a relationship between a Ge concentration and d₃₃ of each piezoelectric thin film in a case where Ge is used as the doping substance.
[Fig. 11] Fig. 11 is a graph showing a relationship between the Ge concentration and the Sc concentration, at which the piezoelectric polarity is reversed, of each piezoelectric thin film in the case where Ge is used as the doping substance.
[Fig. 12] Fig. 12 is a table showing the composition and piezoelectric charge constant (d₃₃) of each piezoelectric thin film in a case where Sn is used as a doping substance and an Sc concentration is fixed to approximately 10 mol%.
[Fig. 13] Fig. 13 is a table showing the composition and piezoelectric charge constant (d₃₃) of each piezoelectric thin film in a case where Sn is used as a doping substance and an Sc concentration is fixed to approximately 20 mol%.
[Fig. 14] Fig. 14 is a table showing the composition and piezoelectric charge constant (d₃₃) of each piezoelectric thin film in a case where Sn is used as a doping substance and an Sc concentration is fixed to approximately 30 mol%.
[Fig. 15] Fig. 15 is a graph showing a relationship between an Sn concentration and d₃₃ of each piezoelectric thin film in a case where Sn is used as the doping substance.
[Fig. 16] Fig. 16 is a graph showing a relationship between the Sn concentration and the Sc concentration, at which the piezoelectric polarity is reversed, of each piezoelectric thin film in the case where Sn is used as the doping substance.
[Fig. 17] Fig. 17 is a table showing the composition and piezoelectric charge constant (d₃₃) in a case where two types of elements are used as doping substances.
[Fig. 18] Fig. 18 is a schematic cross-sectional view of a piezoelectric thin film according to a second embodiment.
[Fig. 19] Fig. 19 is a schematic cross-sectional view of a piezoelectric thin film according to a third embodiment.

### Description of Embodiments

Hereinafter, embodiments of a piezoelectric thin film according to the present invention will be described with reference to the accompanying drawings. The present invention is not limited to the following embodiments. For example, the shapes are not restrictive, and it will be understood that the piezoelectric body do not need to have a thin film shape.

### First embodiment:

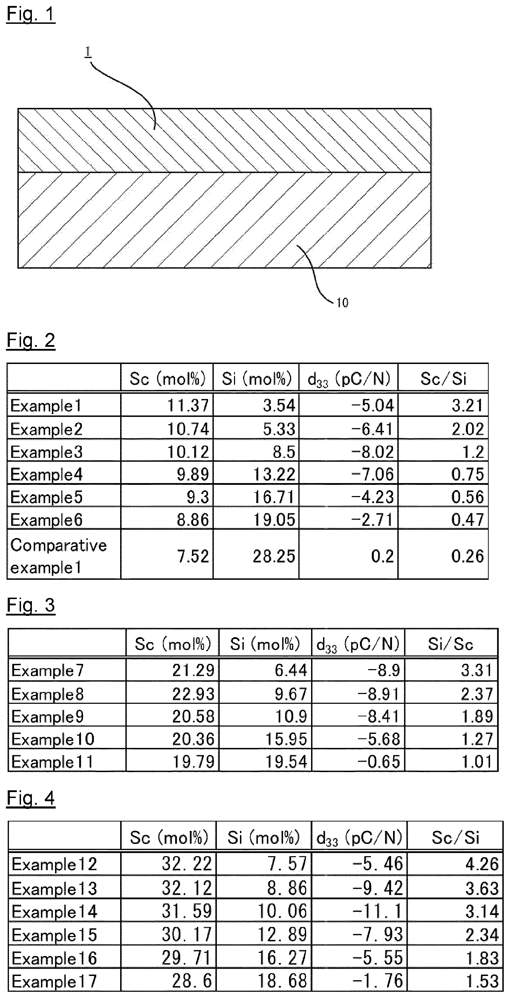

Fig. 1 is a schematic cross-sectional view of a piezoelectric thin film according to the present embodiment. As shown in the diagram, a piezoelectric thin film 1 is formed on a substrate 10. The thickness of the piezoelectric thin film 1 is not limited in particular, and preferably in the range of 0.1 to 30 µm, particularly preferably in the range of 0.1 to 2 µm for excellent adhesion.

The substrate 10 is not particularly limited in terms of thickness, material, or the like as long as the piezoelectric thin film 1 can be formed on its surface. Examples of the substrate 10 include silicon, heat-resistant alloys made of Inconel and the like, and resin films made of polyimide and the like.

The piezoelectric thin film 1 is formed of a nitride material represented by the chemical formula Sc_{X}M_{Y}Al_{1-X-Y}N, where M represents at least one or more elements among silicon (Si), germanium (Ge), and tin (Sn), X is greater than 0 and not greater than 0.4, Y is greater than 0 and not greater than 0.2, and X/Y is less than or equal to 5. If M includes a plurality of elements, the total molar concentration thereof is naturally understood to be Y. The concentration of each element is not limited in particular as long as the concentration falls within the foregoing range.

Unlike conventional scandium (Sc)-doped aluminum nitride, such a piezoelectric thin film 1 has piezoelectricity with a polarization direction of nitrogen polarity (N polarity). M may be any one type of element among silicon, germanium, and tin. Such a nitride material has even higher piezoelectricity with a polarization direction of nitrogen polarity.

If M is only Si, X is preferably greater than 0 and not greater than 0.35, Y is greater than 0 and not greater than 0.2, and X/Y is less than or equal to 5. Y is more preferably less than or equal to 0.03. If M is only Ge, X is preferably greater than 0 and not greater than 0.35, Y is greater than 0 and not greater than 0.2, and X/Y is less than or equal to 5. X/Y is more preferably less than or equal to 4, and Y is particularly preferably greater than or equal to 0.05. If M is only Sn, X is preferably greater than 0 and not greater than 0.35, Y is greater than 0 and not greater than 0.2, and X/Y is less than or equal to 5. Y is more preferably greater than or equal to 0.05. Such piezoelectric thin films have more stable piezoelectricity with a polarization direction of nitrogen polarity.

The main crystals constituting the nitride materials of the foregoing configurations are Wurtzite crystals having nitrogen polarity. The nitride materials are thus considered to have nitrogen polarity as a whole.

High-frequency filters using such piezoelectric thin films 1 thus have low loss and can operate in a wide band compared to conventional high-frequency filters. This enables further high-frequency response, miniaturization, and reduction in electricity usage of portable devices. Note that the high-frequency filters are not particularly limited in configuration, and can be manufactured with publicly known configurations, for example.

Next, a method for manufacturing the piezoelectric thin film 1 according to the present embodiment will be described. Like typical piezoelectric thin films, the piezoelectric thin film 1 can be manufactured by a manufacturing method such as sputtering and evaporation. Specifically, for example, the piezoelectric thin film 1 can be manufactured by simultaneously sputtering a target made of scandium, a target made of the doping substance M (including the case with a plurality of elements), and a target made of aluminum (Al) onto the substrate 10 (for example, silicon [Si] substrate). This sputtering is performed in a nitrogen gas (N₂) atmosphere or a mixed atmosphere of nitrogen gas (N₂) and argon gas (Ar) (at a gas pressure of 1 Pa or less). An alloy containing predetermined ratios of scandium, M, and aluminum may be used as a target.

A layer containing the substance constituting the substrate and the substance constituting the piezoelectric thin film may be formed between the substrate and the piezoelectric thin film. For example, such a layer can be formed by heating the thin film and the substrate after the piezoelectric thin film has formed on the substrate.

### <In case where Si is used as doping substance>

Examples of the nitride material (piezoelectric thin film) according to the present embodiment in a case where Si is used as the doping substance M will be described.

A 0.4- to 1.5-µm-thick piezoelectric thin film of scandium- and silicon-doped (M = Si) aluminum nitride (Sc_{X}Si_{Y}Al_{1-X-Y}N) was fabricated on an n-type silicon substrate having a specific resistance of 0.02 Ωcm, using the following apparatus, sputtering targets, and the like: Multi-element simultaneous sputtering apparatus (manufactured by EIKO Engineering K.K.), Scandium sputtering target material (purity: 99.999%),
Silicon sputtering target material (purity: 99.999%),
Aluminum sputtering target material (purity: 99.999%),
Gas: mixed gas of nitrogen (purity: 99.99995% or higher) and argon gas (purity: 99.9999% or higher) (mixed ratio [nitrogen:argon] 30:70), and
Substrate heating temperature: 200°C

Deposition experiments were conducted in a sputter chamber after the atmospheric pressure inside was reduced to a high vacuum of 10⁻⁵ Pa or lower by a vacuum pump. To avoid contamination of impurities such as oxygen, the target surfaces were cleaned immediately after loading of the targets and immediately before each deposition experiment.

Figs. 2 to 4 show the compositions of the obtained piezoelectric thin films. Fig. 2 shows the composition and piezoelectric charge constant (d₃₃) of each piezoelectric thin film in a case where the Sc concentration was fixed to approximately 10 mol%. Fig. 3 shows the composition and piezoelectric charge constant (d₃₃) of each piezoelectric thin film in a case where the Sc concentration was fixed to approximately 20 mol%. Fig. 4 shows the composition and piezoelectric charge constant (d₃₃) of each piezoelectric thin film in a case where the Sc concentration was fixed to approximately 30 mol%.

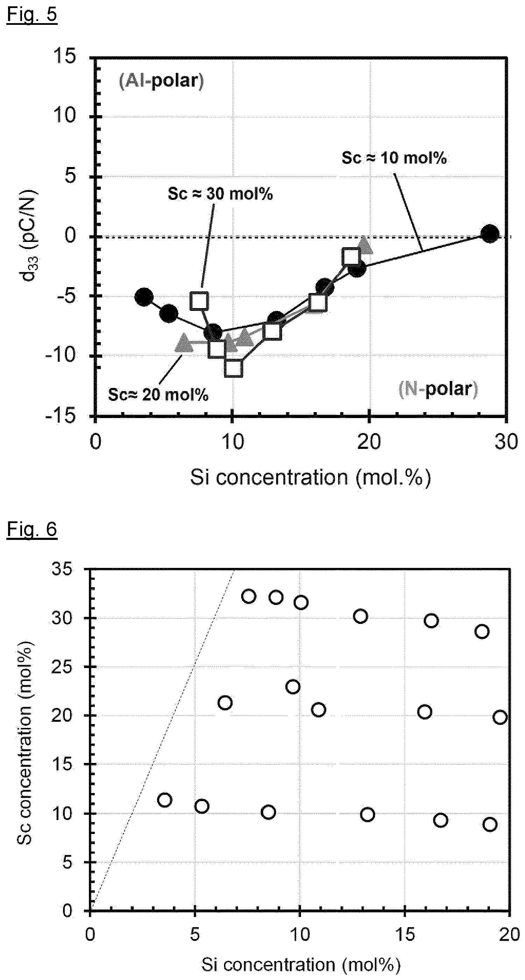

Fig. 5 shows the relationship between the Si concentrations and piezoelectric charge constants (d₃₃) of the piezoelectric thin films shown in Figs. 2 to 4.

In the charts, a positive (plus) d₃₃ value indicates that the polarization direction of the piezoelectric thin film has aluminum polarity. A negative (minus) d₃₃ value indicates that the polarization direction of the piezoelectric thin film has nitrogen polarity.

Next, the Si concentrations and the Sc concentrations at which d₃₃ becomes 0 were determined from a graph such as Fig. 5 by interpolation, extrapolation, or the like. Fig. 6 shows the results.

As can be seen from the chart, the polarization direction of the piezoelectric thin film has nitrogen polarity if the Sc concentration (X) is higher than 0 and not higher than 0.35 (35 mol%), the Si concentration (Y) is higher than 0 and not higher than 0.2 (20 mol%), and X/Y is less than or equal to 5. The dotted line in the chart represents X/Y = 5.

### <In case where Ge is used as doping substance>

Examples of the nitride material (piezoelectric thin film) in a case where Ge is used as the doping substance M will be described.

The manufacturing method for fabrication of the piezoelectric thin films was the same as that for the nitride material using Si as the doping substance except that the following Ge sputtering target was used instead of the Si sputtering target material:
Ge sputtering target material (purity: 99.999%).

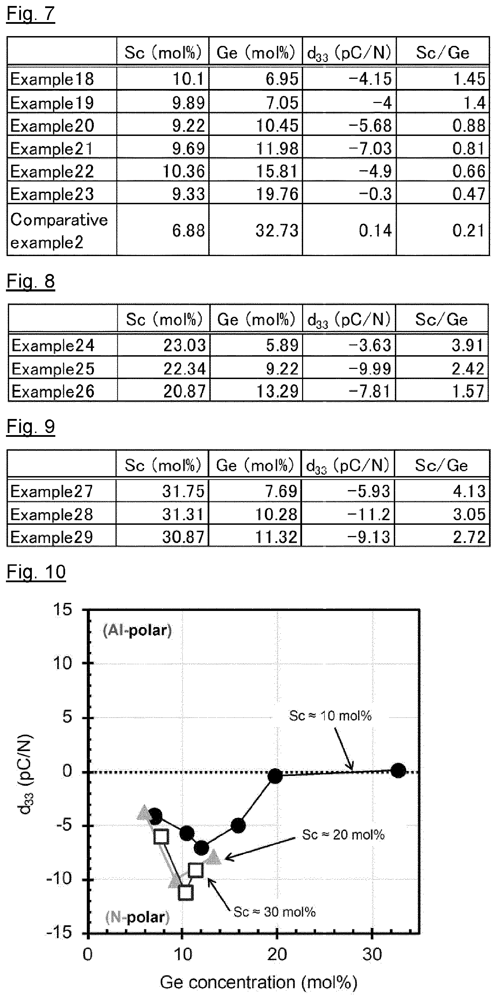

Figs. 7 to 9 show the compositions and d₃₃ of the obtained piezoelectric thin films. Fig. 7 shows the composition and d₃₃ of each piezoelectric thin film in a case where the Sc concentration was fixed to approximately 10 mol%. Fig. 8 shows the composition and d₃₃ of each piezoelectric thin film in a case where the Sc concentration was fixed to approximately 20 mol%. Fig. 9 shows the composition and d₃₃ of each piezoelectric thin film in a case where the Sc concentration was fixed to approximately 30 mol%.

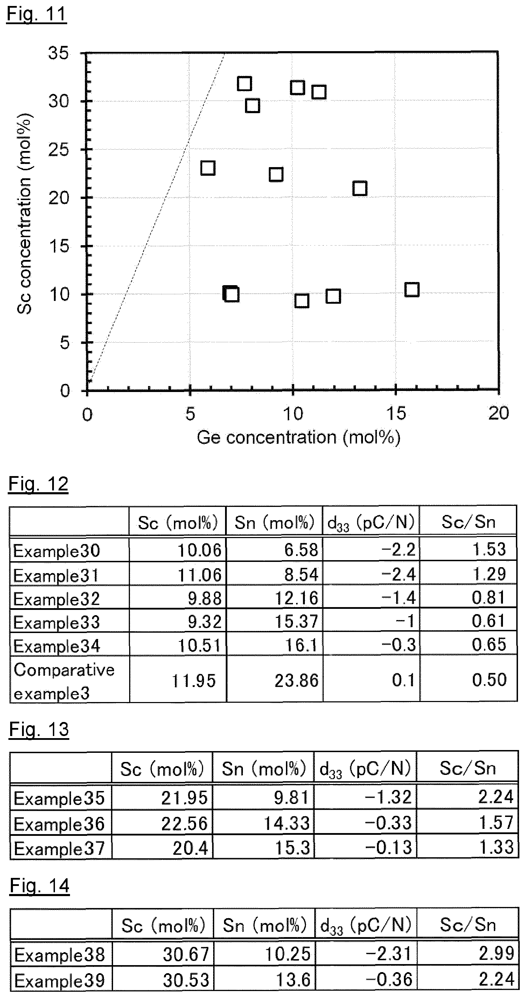

Fig. 10 shows the relationship between the Ge concentrations and d₃₃ of the piezoelectric thin films shown in Figs. 7 to 9. Like in Fig. 6, the Ge concentrations and the Sc concentrations at which d₃₃ becomes 0 were determined from a graph such as Fig. 10 by interpolation, extrapolation, and the like. Fig. 11 shows the results.

As can be seen from the chart, the polarization direction of the piezoelectric thin film has nitrogen polarity if the Sc concentration (X) is higher than 0 and not higher than 0.35 (35 mol%), the Ge concentration (Y) is higher than 0 and not higher than 0.2 (20 mol%), and X/Y is less than or equal to 5. The dotted line in the chart represents X/Y = 5.

### <In case where Sn is used as doping substance>

Examples of the nitride material (piezoelectric thin film) according to the present embodiment in a case where Sn is used as the doping substance M will be described.

The manufacturing method for fabrication of the piezoelectric thin films was the same as that for the nitride material using Si as the doping substance except that the following Sn sputtering target was used instead of the Si sputtering target material:
Sn sputtering target material (purity: 99.999%).

Figs. 12 to 14 show the compositions and d₃₃ of the obtained piezoelectric thin films. Fig. 12 shows the composition and d₃₃ of each piezoelectric thin film in a case where the Sc concentration was fixed to approximately 10 mol%. Fig. 13 shows the composition and d₃₃ of each piezoelectric thin film in a case where the Sc concentration was fixed to approximately 20 mol%. Fig. 14 shows the composition and d₃₃ of each piezoelectric thin film in a case where the Sc concentration was fixed to approximately 30 mol%.

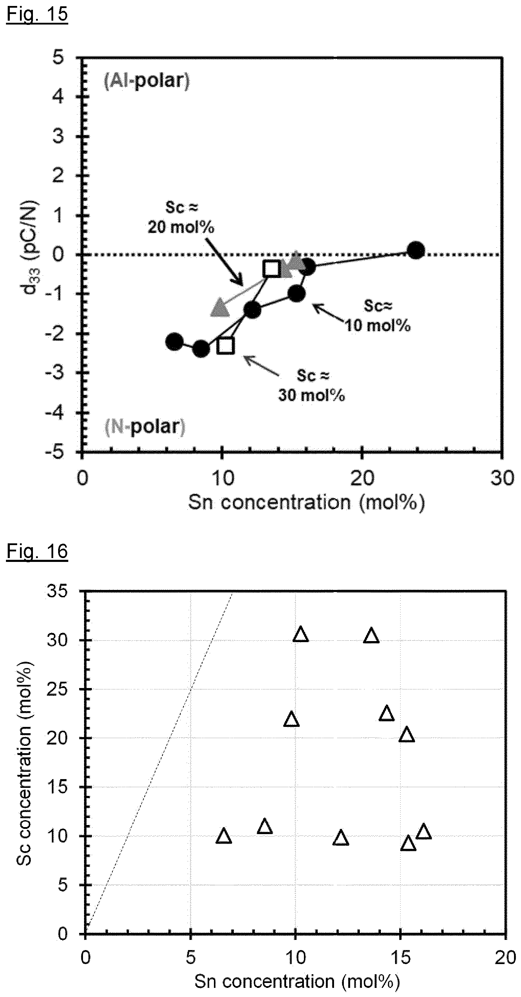

Fig. 15 shows the relationship between the Sn concentrations and d₃₃ of the piezoelectric thin films shown in Figs. 12 to 14. Like in Fig. 6, the Sn concentrations and the Sc concentrations at which d₃₃ becomes 0 were determined from a graph such as Fig. 15 by interpolation, extrapolation, and the like. Fig. 16 shows the results.

As can be seen from the chart, if the Sc concentration (X) is higher than 0 and not higher than 0.35 (35 mol%), the Sn concentration (Y) is higher than 0 and not higher than 0.2 (20 mol%), and X/Y is less than or equal to 5, then the polarization direction of the piezoelectric thin film has nitrogen polarity. The dotted line in the chart represents X/Y = 5.

### <In case where two types of elements are used as doping substance>

Examples of the nitride material (piezoelectric thin film) according to the present **embodiment** in a case where two types of elements (SiSn) are used as the doping substance M will be described.

The manufacturing method for fabrication of the piezoelectric thin films was the same as that for the nitride material using Si as the doping substance except that the following SiSn sputtering target was used instead of the Si sputtering target material:
SiSn sputtering target material (purity: 99.999%).

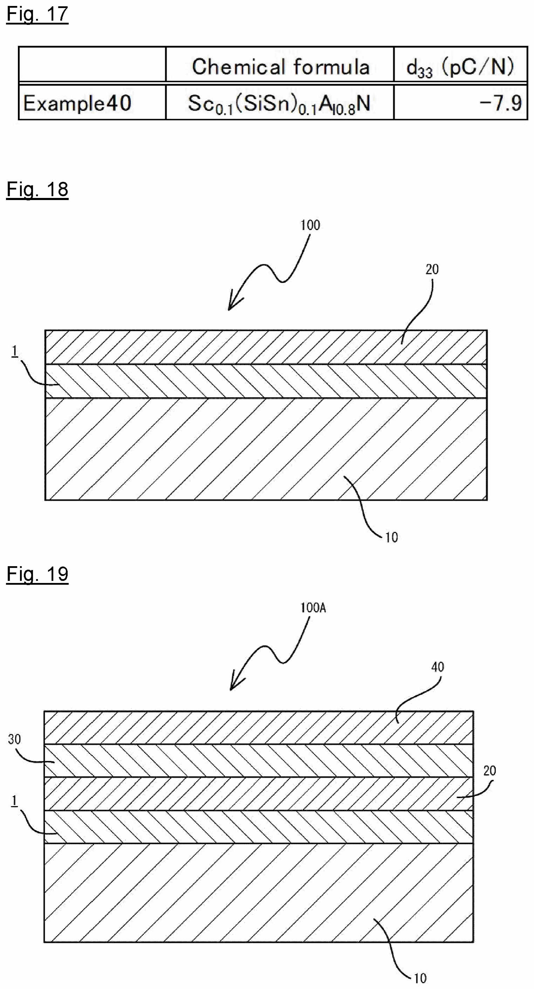

Fig. 17 shows the composition and d₃₃ of each piezoelectric thin film obtained. As is clear from the chart, the polarization direction of the piezoelectric thin film has nitrogen polarity even if two types of elements are used as the doping substance M.

Second embodiment:

In the first embodiment, the piezoelectric body is formed only of the nitride material according to the present embodiment. However, the present invention is not limited thereto. For example, as shown in Fig. 18, a scandium-containing nitride material having aluminum polarity (Sc_{Z}Al_{1-Z}N [0 < Z ≤ 0.4], second layer 20) may be formed on the nitride material according to the first embodiment (first layer) to form a piezoelectric thin film (piezoelectric body) 100 composed of the two layers. The second layer 20 may be formed under the first layer 1. The first layer 1 and the second layer 20 may have the same thickness or different thicknesses.

Given the same thickness, the piezoelectric thin film of such a two-layer structure can vibrate at a higher frequency compared to a piezoelectric thin film consisting only of the piezoelectric thin film according to the foregoing first embodiment or a piezoelectric thin film consisting only of Sc_{Z}Al_{1-Z}N (0 < Z ≤ 0.4). As an additional note, in order to vibrate the piezoelectric thin film, it is only natural that an upper electrode needs to be attached to the top surface of the piezoelectric thin film and a lower electrode to the bottom surface, and a voltage needs to be applied across the electrodes, for example.

### Third embodiment:

In the second embodiment, the piezoelectric thin film with a two-layer structure is produced by forming the scandium-containing nitride material with a polarization direction of aluminum polarity (second layer 20) on the nitride material with a polarization direction of nitrogen polarity (first layer 1). However, the present invention is not limited thereto. For example, as shown in Fig. 19, a piezoelectric thin film (piezoelectric body) 100A with a four-layer structure may be produced by forming, on the thin films of the same configuration as in the second embodiment, two layers (third layer 30 and fourth layer 40) of thin films of the same configuration.

More specifically, a piezoelectric thin film 100A of four-layer structure including the first layer 1 of the nitride material with a polarization direction of nitrogen polarity, the second layer 20 of the scandium-containing nitride material with a polarization direction of aluminum polarity, a third layer 30 of the nitride material with a polarization direction of nitrogen polarity, and a fourth layer 40 of the scandium-containing nitride material with a polarization direction of aluminum polarity may be formed. Note that the stacking order is not limited in particular as long as the adjoining nitride materials have different polarization directions.

Given the same film thickness, the piezoelectric thin film 100A with such a four-layer structure can expand and make wider the frequency bandwidth in which the film can vibrate. This wider bandwidth is in comparison to the piezoelectric thin film consisting only of the piezoelectric thin film according to the foregoing first embodiment, the piezoelectric thin film consisting only of Sc_{Z}Al_{1-Z}N (0 < Z ≤ 0.4), or the piezoelectric thin film according to the second embodiment.

A diffusion layer containing the substance constituting the first layer and the substance constituting the second layer may be formed between the first layer and the second layer. For example, such a diffusion layer can be formed by heating the layers after the second layer has formed on the first layer.

### Fourth embodiment:

In the first embodiment, the piezoelectric thin film is fabricated directly on the substrate. However, the present invention is not limited thereto. For example, an intermediate layer may be provided between the substrate and the piezoelectric thin film. The intermediate layer can be fabricated by sputtering, or the like.

The intermediate layer is not particularly limited in material, thickness, or the like as long as the piezoelectric thin film can be formed on the intermediate layer. Examples of the intermediate layer include 50- to 200-nm-thick layers formed of aluminum nitride (AIN), gallium nitride (GaN), indium nitride (InN), titanium nitride (TiN), scandium nitride (ScN), ytterbium nitride (YbN), molybdenum (Mo), tungsten (W), hafnium (Hf), titanium (Ti), ruthenium (Ru), ruthenium oxide (RuO₂), chromium (Cr), chromium nitride (CrN), platinum (Pt), gold (Au), silver (Ag), copper (Cu), aluminum (Al), tantalum (Ta), iridium (Ir), palladium (Pd), and nickel (Ni).

Since the provision of such an intermediate layer on the substrate improves the crystallinity (degree of crystallization) of the piezoelectric thin film, a piezoelectric thin film having a high piezoelectric charge constant d₃₃ compared to the piezoelectric thin film of the first embodiment can be manufactured.

### Other embodiments:

The piezoelectric body according to the third embodiment has a four-layer structure. However, the present invention is not limited thereto. A piezoelectric thin film may be produced by stacking more layers formed of nitride materials having polarization directions different from those of adjoining nitride materials.

Such a piezoelectric thin film can vibrate at a higher frequency and over an expanded wider frequency bandwidth compared to the piezoelectric thin film of the third embodiment.

For example, the piezoelectric thin film is not limited to one including a stack of an even number of layers, which are formed of nitride materials with polarization directions different from those of adjoining nitride materials. A piezoelectric thin film including a stack of an odd number of layers (for example, piezoelectric thin film of three-layer structure) may be produced.

The nitride material (piezoelectric body) according to the present invention described above can be used for a MEMS. The MEMS using the nitride material according to the present invention can vibrate at high frequency, and the use of the piezoelectric body having high piezoelectricity enables provision of a MEMS device that can contribute to a higher frequency support, miniaturization, and reduction in electricity usage of a portable device. The MEMS may have a conventional configuration, for example.

Moreover, while the first embodiment has been described by using a piezoelectric thin film using the nitride material according to the present invention as an example, the present invention is not limited thereto. For example, the nitride material according to the present invention can also be applied to a MEMS device, a transistor, an inverter, a transducer, a SAW device, or a ferroelectric memory. The transistor using the nitride material according to the present invention can operate at high speed with low loss and high output compared to conventional transistors. The inverter using the nitride material according to the present invention has a high dielectric withstand voltage and low loss compared to conventional inverters. Furthermore, the ferroelectric memory using the nitride material according to the present invention has high spontaneous polarization and high storage performance compared to conventional ferroelectric memories. Moreover, a high-frequency wideband transducer using nitride materials of different polarities can be provided. Furthermore, a SAW device that vibrates at high frequency compared to typical IDT-SAW devices can be provided by constituting an IDT using a piezoelectric body formed of nitride materials of different polarities. Such a transistor, inverter, transducer, SAW device, and ferroelectric memory may be constituted by that which is conventionally known.

### Reference Signs List

- 1: piezoelectric thin film (first layer)
- 10: substrate
- 20: second layer
- 30: third layer
- 40: fourth layer
- 100, 100A: piezoelectric thin film

## Claims

1. **A nitride** material represented by the chemical formula Sc_{X}M_{Y}Al_{1-X-Y}N, wherein:
M is at least one or more elements among Si, Ge, and Sn;
X is greater than 0 and not greater than 0.4;
Y is greater than 0 and not greater than 0.2; and
X/Y is less than or equal to 5.

2. The nitride material according to claim 1, wherein M is any one element among Si, Ge, and Sn.

3. The nitride material according to claim 2, wherein:
X is greater than 0 and not greater than 0.35;
Y is greater than 0 and not greater than 0.2; and
X/Y is less than or equal to 5.

4. A nitride material comprising the nitride material according to any one of claims 1 to 3, the nitride material being disposed on a substrate, wherein
at least one intermediate layer is disposed between the nitride material and the substrate.

5. The nitride material according to claim 4, wherein the intermediate layer contains at least one of aluminum nitride, gallium nitride, indium nitride, titanium nitride, scandium nitride, ytterbium nitride, molybdenum, tungsten, hafnium, titanium, ruthenium, ruthenium oxide, chromium, chromium nitride, platinum, gold, silver, copper, aluminum, tantalum, iridium, palladium, and nickel.

6. A piezoelectric thin film formed of the nitride material according to any one of claims 1 to 5.

7. A piezoelectric body comprising the nitride material according to any one of claims 1 to 5, wherein the nitride material is disposed on a surface of a scandium-containing nitride material represented by the chemical formula Sc_{Z}Al_{1-Z}N (0 < Z ≤ 0.4).

8. A piezoelectric body comprising a stack of at least two or more piezoelectric bodies according to claim 7.

9. A MEMS device using the piezoelectric thin film according to claim 6 or a piezoelectric body according to any one of claims 7 to 8.

10. A transistor, an inverter, a transducer, a SAW device, or a ferroelectric memory using the nitride material according to any one of claims 1 to 5.

## Patentansprüche

1. Ein Nitridmaterial, dargestellt durch die chemische Formel Sc_{Z}M_{Y}Al_{1-Z-Y}N, wobei:
M mindestens ein oder mehrere Elemente aus Si, Ge und Sn ist;
X größer als 0 und nicht größer als 0,4 ist;
Y größer als 0 und nicht größer als 0,2 ist; und
X/Y kleiner oder gleich 5 ist.

2. Das Nitridmaterial nach Anspruch 1, wobei M eines der Elemente Si, Ge und Sn ist.

3. Das Nitridmaterial nach Anspruch 2, wobei:
X größer als 0 und nicht größer als 0,35 ist;
Y größer als 0 und nicht größer als 0,2 ist; und
X/Y kleiner oder gleich 5 ist.

4. Ein Nitridmaterial, umfassend das Nitridmaterial nach einem der Ansprüche 1 bis 3, wobei das Nitridmaterial auf einem Substrat angeordnet ist, wobei
mindestens eine Zwischenschicht zwischen dem Nitridmaterial und dem Substrat angeordnet ist.

5. Das Nitridmaterial nach Anspruch 4, wobei die Zwischenschicht mindestens eines der folgenden Elemente enthält: Aluminiumnitrid, Galliumnitrid, Indiumnitrid, Titannitrid, Scandiumnitrid, Ytterbiumnitrid, Molybdän, Wolfram, Hafnium, Titan, Ruthenium, Rutheniumoxid, Chrom, Chromnitrid, Platin, Gold, Silber, Kupfer, Aluminium, Tantal, Iridium, Palladium und Nickel.

6. Ein piezoelektrischer Dünnfilm, gebildet aus dem Nitridmaterial nach einem der Ansprüche 1 bis 5.

7. Ein piezoelektrischer Körper umfassend das Nitridmaterial nach einem der Ansprüche 1 bis 5, wobei das Nitridmaterial auf einer Oberfläche eines Scandium enthaltenden Nitridmaterials angeordnet ist, das durch die chemische Formel Sc_{Z}Al_{1-Z}N (0 < Z ≤ 0,4) dargestellt ist.

8. Ein piezoelektrischer Körper, umfassend einen Stapel von mindestens zwei oder mehr piezoelektrischen Körpern nach Anspruch 7.

9. Eine MEMS-Vorrichtung, welche den piezoelektrischen Dünnfilm nach Anspruch 6 oder einen piezoelektrischen Körper nach einem der Ansprüche 7 bis 8 verwendet.

10. Ein Transistor, ein Inverter, ein Wandler, eine SAW-Vorrichtung oder ein ferroelektrischer Speicher, der/die des Nitridmaterial nach einem der Ansprüche 1 bis 5 verwendet.

## Revendications

1. Un matériau nitrure représenté par la formule chimique Sc_{X}M_{Y}Al_{1-X-Y}N, dans lequel :
M est au moins un ou plusieurs éléments choisi(s) parmi Si, Ge et Sn ;
X est supérieur à 0 et pas supérieur à 0,4 ;
Y est supérieur à 0 et pas supérieur à 0,2 ; et
X/Y est inférieur ou égal à 5.

2. Le matériau nitrure selon la revendication 1, dans lequel M est un élément quelconque choisi parmi Si, Ge et Sn.

3. Le matériau nitrure selon la revendication 2, dans lequel :
X est supérieur à 0 et pas supérieur à 0,35 ;
Y est supérieur à 0 et pas supérieur à 0,2 ; et
X/Y est inférieur ou égal à 5.

4. Un matériau nitrure comprenant le matériau nitrure selon l'une quelconque des revendications 1 à 3, le matériau nitrure étant disposé sur un substrat, dans lequel
au moins une couche intermédiaire est disposée entre le matériau nitrure et le substrat.

5. Le matériau nitrure selon la revendication 4, dans lequel la couche intermédiaire contient au moins l'un parmi le nitrure d'aluminium, le nitrure de gallium, le nitrure d'indium, le nitrure de titane, le nitrure de scandium, le nitrure d'ytterbium, le molybdène, le tungstène, le hafnium, le titane, le ruthénium, l'oxyde de ruthénium, le chrome, le nitrure de chrome, le platine, l'or, l'argent, le cuivre, l'aluminium, le tantale, l'iridium, le palladium et le nickel.

6. Un film mince piézoélectrique formé du matériau nitrure selon l'une quelconque des revendications 1 à 5.

7. Un corps piézoélectrique comprenant le matériau nitrure selon l'une quelconque des revendications 1 à 5, dans lequel le matériau nitrure est disposé sur une surface d'un matériau nitrure contenant du scandium représenté par la formule chimique Sc_{Z}Al_{1-Z}N (0 < Z ≤ 0,4).

8. Un corps piézoélectrique comprenant un empilement d'au moins deux corps piézoélectriques ou plus selon la revendication 7.

9. Un dispositif MEMS utilisant le film mince piézoélectrique selon la revendication 6 ou un corps piézoélectrique selon l'une quelconque des revendications 7 à 8.

10. Un transistor, un inverseur, un transducteur, un dispositif SAW, ou une mémoire ferroélectrique utilisant le matériau nitrure selon l'une quelconque des revendications 1 à 5.
